# EUROPEAN PATENT APPLICATION

(11) **EP 3 181 246 A1**
(43) Date of publication of application: **21.06.2017**
(21) Application number: 15290312.6
(22) Date of filing: 15.12.2015
(51) Int. Cl.: B06B 1/06

(54) **APODIZATION OF PIEZO-COMPOSITE ACOUSTIC ELEMENTS**

(71) Applicant: Services Pétroliers Schlumberger, 75007 Paris (FR); Schlumberger Holdings Limited, Road Town, Tortola (VG); Schlumberger Technology B.V., 2514 JG The Hague (NL)
(72) Inventor: Lemarenko, Mikhail, 92140 Clamart (FR); Klieber, Christoph, 92140 Clamart (FR); Hayman, Andrew John, 92140 Clamart (FR)
(74) Representative: Rzaniak, Martin

(57) **Abstract**

A transducer configured to be used in a downhole tool includes a radiating face to emit or receive an acoustic signal, a front electrode, a central layer behind the front electrode, and a back electrode behind the central layer, having a back face coupled to a backing material. The central layer has a substantially constant thickness throughout and includes a piezo-composite body and an insulating material. A configuration between the piezo-composite body and the insulating material variably reduces the central layer to reduce generation of side lobes.

## Description

### BACKGROUND

This disclosure relates to improving the quality of well log data by apodization of ultrasonic elements to remove artifacts and enable simpler approximation of excitation profiles.

This section is intended to introduce the reader to various aspects of art that may be related to various aspects of the present techniques, which are described and/or claimed below. This discussion is believed to be helpful in providing the reader with background information to facilitate a better understanding of the various aspects of the present disclosure. Accordingly, it should be understood that these statements are to be read in this light, and not as admissions.

When a well is drilled into a geological formation, logging tools are used to determine a variety of characteristics of the well as well as making detailed records of geologic formations penetrated by the well, generally known as well logging or borehole logging. Well logging is performed for the oil and gas, groundwater, mineral and geothermal exploration as well as part of environmental and geotechnical studies. Some logging tools may determine characteristics of the surrounding rock formation and some logging tools may determine when cement has been properly installed in the well to achieve zonal isolation. In the example of cement evaluation, a wellbore may be targeted to produce oil and/or gas from certain zones of the geological formation. To prevent zones from interacting with one another via the wellbore and to prevent fluids from undesired zones entering the wellbore, the wellbore may be completed by placing a cylindrical casing into the wellbore and cementing the annulus between the casing and the wall of the wellbore. During cementing, cement may be injected into the annulus formed between the cylindrical casing and the geological formation. When the cement properly sets, fluids from one zone of the geological formation may not be able to pass through the wellbore to interact with one another. This desirable condition is referred to as "zonal isolation." Yet well completions may not go as planned. For example, the cement may not set as planned and/or the quality of the cement may be less than expected. In other cases, the cement may unexpectedly fail to set above a certain depth due to natural fissures in the formation.

A variety of acoustic tools may be used for well logging. These acoustic tools may use pulse acoustic waves (e.g., sonic or ultrasonic waves) as they are moved through the wellbore to obtain acoustic evaluation data at various depths and azimuths in the wellbore. The acoustic evaluation data may include not just the signal relating to characteristics of the well (e.g., quality of the cement), but also artifacts of the tool and other sources. For example, the generation and transmission of the ultrasonic waves may show a pattern of lobes at various directions, including a main (central) lobe and other lobes to the side of the main lobe, called side lobes. Though the energy density of side lobes is generally less than that of the main lobe, it may still produce artifacts (e.g., artifacts created by the emitted side lobes reflected back from a target, interfere with each other and the main lobe which may modify the signal properties, and the resulting signal is then erroneously displayed). Furthermore, casings are increasingly being installed using lighter cements that have acoustic properties more similar to fluids than heavier cements. These lighter cements may be difficult to detect without higher precision of the measurement. Accordingly, reducing the artifacts in ultrasonic measurements and at the same time improving computational efficiency may enable more accurate and/or precise determinations of cement installation quality as well as other characteristics of the well.

### SUMMARY

A summary of certain embodiments disclosed herein is set forth below. It should be understood that these aspects are presented merely to provide the reader with a brief summary of these certain embodiments and that these aspects are not intended to limit the scope of this disclosure. Indeed, this disclosure may encompass a variety of aspects that may not be set forth below.

Systems and methods of this disclosure reduce the generation of side lobes in an acoustic transducer. In a first example, a transducer configured to emit or receive an acoustic signal includes a front electrode, and a central layer behind the front electrode. The central layer has a substantially constant first thickness from a central point to an edge of the central layer. The central layer includes a piezo-composite body having a second thickness within the first thickness, wherein the second thickness of the piezo-composite body varies from the central point to the edge. The central layer also includes an insulating material having a third thickness, wherein the third thickness of the insulating material varies from the central point to the edge in an opposite manner to the second thickness. The first thickness is equal to the second thickness plus the third thickness. The transducer also includes a back electrode behind the central layer, having a back face coupled to a backing material. Variations in the second thickness of the piezo-composite body and the third thickness of the insulating material from the central point to the edge cause the piezo-composite body to cause reduced side lobes in comparison to a different transducer with another piezo-composite body having the disk-like geometry but a single thickness that does not vary from the central point to the edge.

In a second example, a method for making a transducer configured to reduce side lobes includes providing a central layer between a front electrode and a back electrode of the transducer, wherein the central layer has a substantially constant first thickness throughout. The central layer includes a piezo-composite body having a second thickness along an axial direction, and a width along a radial direction towards an radial edge, and an insulating material having a third thickness. The method for making a transducer configured to reduce side lobes also includes varying the second thickness of the piezo-composite body to differ in various locations along the radial direction towards the radial edge. The method for making a transducer configured to reduce side lobes further includes varying the third thickness of the insulating material such that the first thickness of the central layer comprises the third thickness of the insulating material combined with the second thickness of the piezo-composite body.

In a third example, a downhole tool includes a rotating measurement component configured to rotate to obtain measurements at a plurality of azimuthal angles in a well, wherein the rotating measurement component includes one or more transducers configured to emit acoustic signals at each of the plurality of azimuthal angles in the well and detect acoustic return waveforms that result when the emitted acoustic signals interact with the well. Each of the one or more ultrasonic transducers includes a front, and a central layer behind the front electrode. The central layer has a substantially constant thickness throughout and includes a piezo-composite body and an insulating material. Each of the one or more ultrasonic transducers also includes a back electrode behind the central layer, having a back face configured to be coupled to a backing material.

Various refinements of the features noted above may be undertaken in relation to various aspects of the present disclosure. Further features may also be incorporated in these various aspects as well. These refinements and additional features may exist individually or in any combination. For instance, various features discussed below in relation to one or more of the illustrated embodiments may be incorporated into any of the above-described aspects of the present disclosure alone or in any combination. The brief summary presented above is intended to familiarize the reader with certain aspects and contexts of embodiments of the present disclosure without limitation to the claimed subject matter.

### BRIEF DESCRIPTION OF THE DRAWINGS

Various aspects of this disclosure may be better understood upon reading the following detailed description and upon reference to the drawings in which:
FIG. 1 is a schematic of a system for obtaining well logging data with reduced artifacts, in accordance with an embodiment;
FIG. 2 is a schematic of an acoustic downhole tool that may be used to obtain the well logging data, in accordance with an embodiment;
FIG. 3A illustrates an excitation profile of a non-apodized ultrasonic transducer in comparison to a Gaussian profile, in accordance with an embodiment;
FIG. 3B illustrates a pattern of a pressure field perpendicular to a front face of a non-apodized ultrasonic transducer at a location that is far from the non-apodized ultrasonic transducer in comparison to a Gaussian profile, in accordance with an embodiment;
FIG. 4 is a cross-sectional view of an apodized piezo-composite ultrasonic transducer, in accordance with an embodiment;
FIG. 5 illustrates the effectiveness of apodizing the transducer to a given fraction of its full response, in accordance with an embodiment;
FIG. 6 illustrates a piezo-composite body including an active piezoelectric material element and grooves filled with an insulating material, in accordance with an embodiment;
FIG. 7 illustrates a piezo-composite body including an active piezoelectric material element and a tapered region filled with an insulating material, in accordance with an embodiment;
FIG. 8 illustrates a piezo-composite body including an active piezoelectric material element and a tapered region filled with different insulating materials which further divide the tapered region into sub-regions, in accordance with an embodiment;
FIG 9 illustrates a piezo-composite body including an active piezoelectric material element and strips filled with an insulating material, in accordance with an embodiment; and
FIG 10 illustrates a top view of a piezo-composite body and irregularly shaped regions filled with an insulating material, in accordance with an embodiment.

### DETAILED DESCRIPTION

One or more specific embodiments of the present disclosure will be described below. These described embodiments are examples of the presently disclosed techniques. Additionally, in an effort to provide a concise description of these embodiments, features of an actual implementation may not be described in the specification. It should be appreciated that in the development of any such actual implementation, as in any engineering or design project, numerous implementation-specific decisions may be made to achieve the developers' specific goals, such as compliance with system-related and business-related constraints, which may vary from one implementation to another. Moreover, it should be appreciated that such a development effort might be complex and time consuming, but would be a routine undertaking of design, fabrication, and manufacture for those of ordinary skill having the benefit of this disclosure.

When introducing elements of various embodiments of the present disclosure, the articles "a," "an," and "the" are intended to mean that there are one or more of the elements. The terms "comprising," "including," and "having" are intended to be inclusive and mean that there may be additional elements other than the listed elements. Additionally, it should be understood that references to "one embodiment" or "an embodiment" of the present disclosure are not intended to be interpreted as excluding the existence of additional embodiments that also incorporate the recited features.

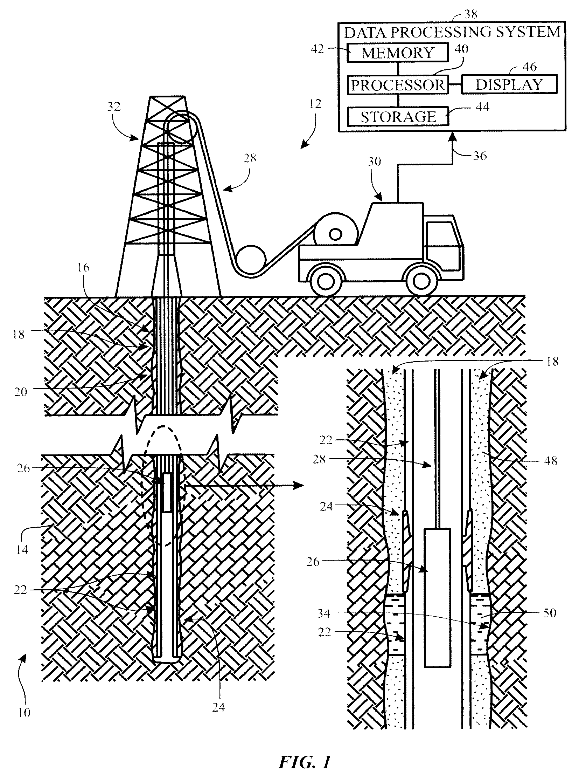

FIG. 1 illustrates a system 10 for obtaining well logging data with reduced artifacts using a downhole tool (e.g., an acoustic logging tool). In particular, FIG. 1 illustrates surface equipment 12 above a geological formation 14. In the example of FIG. 1, a drilling operation has previously been carried out to drill a wellbore 16. In addition, an annular fill 18 (e.g., cement) has been used to seal an annulus 20-the space between the wellbore 16 and casing joints 22 and collars 24-with cementing operations.

As seen in FIG. 1, several casing joints 22 (also referred to below as casing 22) are coupled together by the casing collars 24 to stabilize the wellbore 16. The casing joints 22 represent lengths of pipe, which may be formed from steel or similar materials. In one example, the casing joints 22 each may be approximately 13 m or 40 ft long, and may include an externally threaded (male thread form) connection at each end. A corresponding internally threaded (female thread form) connection in the casing collars 24 may connect two nearby casing joints 22. Coupled in this way, the casing joints 22 may be assembled to form a casing string to a suitable length and specification for the wellbore 16. The casing joints 22 and/or collars 24 may be made of carbon steel, stainless steel, or other suitable materials to withstand a variety of forces, such as collapse, burst, and tensile failure, as well as chemically aggressive fluid.

The surface equipment 12 may carry out various well logging operations to detect conditions of the wellbore 16. The well logging operations may measure parameters of the geological formation 14 (e.g., resistivity or porosity) and/or the wellbore 16 (e.g., temperature, pressure, fluid type, or fluid flowrate). Other measurements may provide acoustic evaluation data (e.g., flexural attenuation and/or acoustic impedance) that may be used to verify the cement installation and the zonal isolation of the wellbore 16. One or more acoustic logging tools 26 may obtain some of these measurements.

The example of FIG. 1 shows the acoustic logging tool 26 being conveyed through the wellbore 16 by a cable 28. Such a cable 28 may be a mechanical cable, mechanical cable attached to an electrical cable, or an electro-optical cable that includes a fiber line protected against the harsh environment of the wellbore 16. In other examples, however, the acoustic logging tool 26 may be conveyed using any other suitable conveyance, such as coiled tubing. The acoustic logging tool 26 may be, for example, an UltraSonic Imager (USI) tool and/or an Isolation Scanner (IS) tool by Schlumberger Technology Corporation. The acoustic logging tool 26 may obtain measurements of acoustic impedance from ultrasonic waves and/or flexural attenuation. For instance, the acoustic logging tool 26 may obtain a pulse echo measurement that exploits the thickness mode (e.g., in the manner of an ultrasonic imaging tool) or may perform a pitch-catch measurement that exploits the flexural mode (e.g., in the manner of an IS tool). These measurements may be used as acoustic evaluation data to identify likely locations where solid, liquid, or gas is located in the annulus 20 behind the casing 22.

The acoustic logging tool 26 may be deployed inside the wellbore 16 by the surface equipment 12, which may include a vehicle 30 and a deploying system such as a drilling rig 32. Data related to the geological formation 14 or the wellbore 16 gathered by the acoustic logging tool 26 may be transmitted to the surface, and/or stored in the acoustic logging tool 26 for later processing and analysis. As will be discussed further below, the vehicle 30 may be fitted with or may communicate with a computer and software to perform data collection and analysis.

FIG. 1 also schematically illustrates a magnified view of a portion of the cased wellbore 16. As mentioned above, the acoustic logging tool 26 may obtain acoustic evaluation data relating to the presence of solids, liquids, or gases behind the casing 22. For instance, the acoustic logging tool 26 may obtain measures of acoustic impedance and/or flexural attenuation, which may be used to determine where the material behind the casing 22 is a solid (e.g., properly set cement) or is not solid (e.g., is a liquid or a gas). When the acoustic logging tool 26 provides such measurements to the surface equipment 12 (e.g., through the cable 28), the surface equipment 12 may pass the measurements as acoustic evaluation data 36 to a data processing system 38 that includes a processor 40, memory 42, storage 44, and/or a display 46. In other examples, the acoustic cement evaluation data 36 may be processed by a similar data processing system 38 at any other suitable location. The data processing system 38 may collect the acoustic evaluation data 36, remove unwanted noises and artifacts, and determine whether such data 36 represents a solid, liquid, or gas using any suitable processing (e.g., T³ processing, *Traitement Très Tôt,* or Very Early Processing). One example of this processing technique is described in U.S. Patent No. 5,216,638, "Method and Apparatus for the Acoustic Investigation of a Casing Cemented in a Borehole," which is assigned to Schlumberger Technology Corporation and is incorporated by reference herein in its entirety for all purposes. To do this, the processor 40 may execute instructions stored in the memory 42 and/or storage 44. As such, the memory 42 and/or the storage 44 of the data processing system 38 may be any suitable article of manufacture that can store the instructions. The memory 42 and/or the storage 44 may be ROM memory, random-access memory (RAM), flash memory, an optical storage medium, or a hard disk drive, to name a few examples. The display 46 may be any suitable electronic display that can display the logs and/or other information relating to classifying the material in the annulus 20 behind the casing 22.

In this way, the acoustic evaluation data 36 from the acoustic logging tool 26 may be used to determine whether cement of the annular fill 18 has been installed as expected. In some cases, the acoustic evaluation data 36 may indicate that the cement of the annular fill 18 has a generally solid character (e.g., as indicated at numeral 48) and therefore has properly set. In other cases, the acoustic evaluation data 36 may indicate the potential absence of cement or that the annular fill 18 has a generally liquid or gas character (e.g., as indicated at numeral 50), which may imply that the cement of the annular fill 18 has not properly set. For example, when the indicate the annular fill 18 has the generally liquid character as indicated at numeral 50, this may imply that the cement is either absent or was of the wrong type or consistency, and/or that fluid channels have formed in the cement of the annular fill 18. By processing the acoustic evaluation data 36 to remove noises and artifacts, ascertaining the character of the annular fill 18 may be more accurate and/or precise than comparable processing when the noises and artifacts remains in the acoustic evaluation data 36.

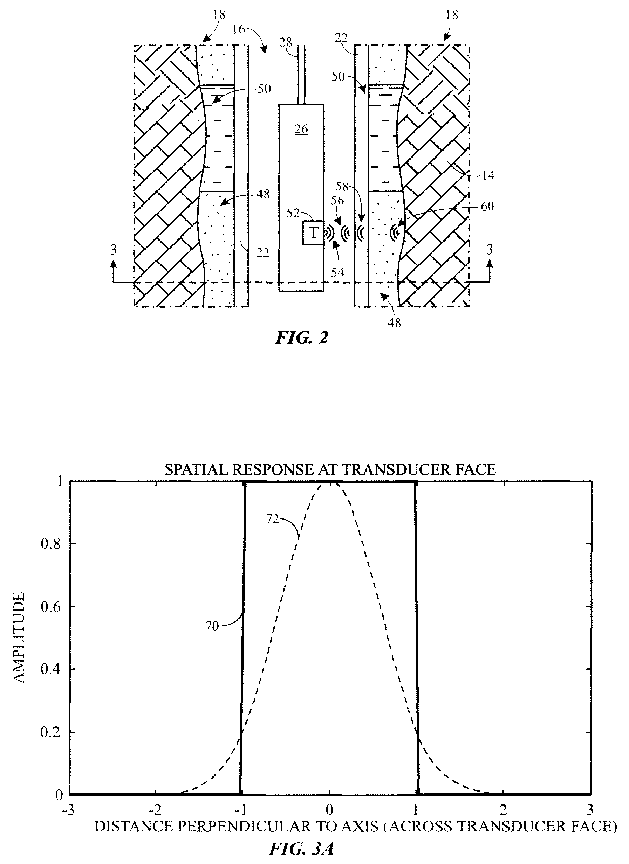

With this in mind, FIG. 2 provides an example of the operation of the acoustic logging tool 26 in the wellbore 16. Specifically, an ultrasonic transducer 52 in the acoustic logging tool 26 may emit acoustic waves 54 out toward the casing 22. Reflected waves 56, 58, and 60 may correspond to acoustic interactions with the casing 22, the annular fill 18, and/or the geological formation 14 or an outer casing. The reflected waves 56, 58, and 60 may vary depending on whether the annular fill 18 is of the generally solid character 48 or the generally liquid or gas character 50. The acoustic logging tool 26 may use any suitable number of different techniques, including measurements in a pulse-echo geometry and/or flexural attenuation, to name a few.

As noted above, the acoustic evaluation data 36 may contain unwanted noise and artifacts such as side lobes in the transducer radiation pattern. Side lobes are caused by sound energy that spreads out from the transducer at angles other than the primary path. The ultrasound beam structure emitted off axis may interfere with the main contribution or itself, which leads to unwanted artifacts and is difficult to model mathematically. Shaping of the excitation profile of an ultrasonic transducer may be done by shaping the emission profile, for example by disabling certain areas of the transducer through shaping or patterning the electrodes of the ultrasonic transducer. Ideally, this structure is sub-wavelength (i.e. smaller) than the ultrasonic wavelength of interest. However, under certain conditions, the ultrasonic transducer is protected with a front face made of electrically conductive materials, whereas the conductivity of the front face rules out the use of shaped/patterned electrodes. In these cases, alternative approaches are taken to taper the transducer excitation towards the edges of the aperture in order to reduce side lobes and shape the excitation profile to better match simple mathematical models. Simpler mathematical models may be easier to implement in computing code and may save significant computational time for the data processing system 38. Accordingly, one example of the disclosure involves altering the emission profile of the transducer to shape the excitation profile. The apodized excitation profile may approximate a mathematical model (e.g., a Gaussian profile and/or any other suitable profile).

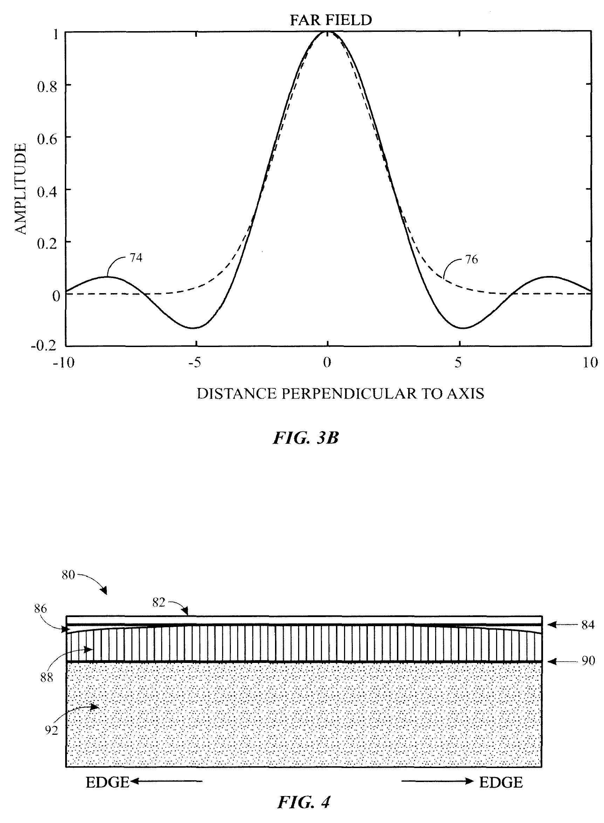

With this in mind, FIG. 3A shows an example of an excitation profile 70 of a non-apodized ultrasonic transducer, in comparison to a Gaussian profile 72. The excitation profile 70 exhibits an abrupt transition at the edges of the piezo-electrically active area (e.g., distance perpendicular to axis (across transducer face) is zero) and departs sharply from the Gaussian profile 72. FIG. 3B shows an example of a pressure field pattern 74 of a non-apodized ultrasonic transducer at a location that is far from the non-apodized ultrasonic transducer, in comparison to a Gaussian profile 76. At a location that is far from the none-apodized ultrasonic transducer (e.g., distance perpendicular to emission axis is large), the profile 74 has side lobes while the Gaussian profile 76 is nearly flat. In one embodiment, the tapering of the amplitude of the side lobes and shaping the excitation profile to better match simple mathematical models (e.g., a Gaussian profile) may enable optimizing computation time in signal analyzing and processing (e.g., the use for fast and lightweight simulations of ultrasonic wave propagation).

To achieve the abovementioned apodization of a transducer, in one embodiment, certain areas of the transducer are disabled/attenuated. As an example, FIG. 4 shows a cross sectional view of an apodized ultrasonic pulse-echo transducer 80 with a disk-like geometry (e.g., a disk-like geometry having a circular shape, an elliptical shape or any other suitable shapes). The transducer 80 includes electrodes on both front and back faces: a front electrode 84 on a front face and a back electrode 90 on a back face. The front face is protected by a front layer 82 which may also serve as or can be a front electrode if it is electrically conductive. The back face is coupled to a backing material 92 that serves the dual functions of damping the vibrations of a piezoelectric material element 88 and attenuating the waves transmitted backwards into the backing. In addition, to apodize the response, an insulating material element 86 is introduced between the front of the piezoelectric material element 88 and the front electrode 84. The layer of the insulating material element 86 may be thicker towards the edge of the transducer in order to taper the response off towards the edge. In another embodiment, the thickness of the insulating material element 86 may be approximately 5% or less than 5% of the thickness of piezoelectric material element 88. The piezoelectric material element 88 is matched to accommodate the insulating material element 86 and leaves the front layer 82 and the front electrode 84 flat (e.g., without shaping/patterning of the front layer 82 and front electrode 84). In order to reduce the electric field seen by the piezoelectric material element 88 on transmission and reduce the current on reception, the insulating material element 86 is a dielectric material with a much lower permittivity than that of the piezoelectric material.

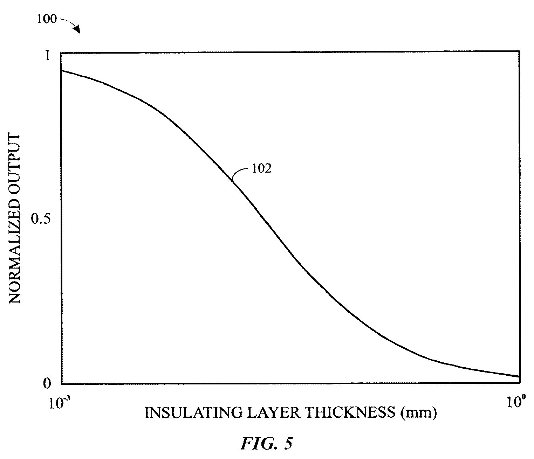

In one embodiment, such an ultrasonic transducer includes a piezoelectric material or a piezo-composite active element including piezoelectric rods in an epoxy matrix, an epoxy insulation layer, a front electrode, a front face made of stainless steel, titanium or a gas-proof elastomer such as Chemraz® Perfluoelastomer and finally a backing material. Referring to FIG. 5, the thickness of the insulating material element may have direct impacts on the effectiveness in tapering off the response; as illustrated is the epoxy thickness required to apodize the transducer to a given fraction of its full response. The profile 102 is obtained based on a normalized output versus epoxy thickness for a 2.5 mm thick piezo-composite, assuming relative permittivities of 600 for the piezo-composite and 5 for the epoxy insulator and a piezo-composite thickness of 2.5 mm. In some cases, it may be desirable to have the normalized outputs above around 0.5 (50%); however, it may be difficult to achieve because of the very thin layer required (< 20 µm) according to profile 102. In such a case, in order to allow the use of a thicker insulating layer that is easier to manufacture, a high-permittivity filler (e.g., ceramic powder) may be included in the epoxy.

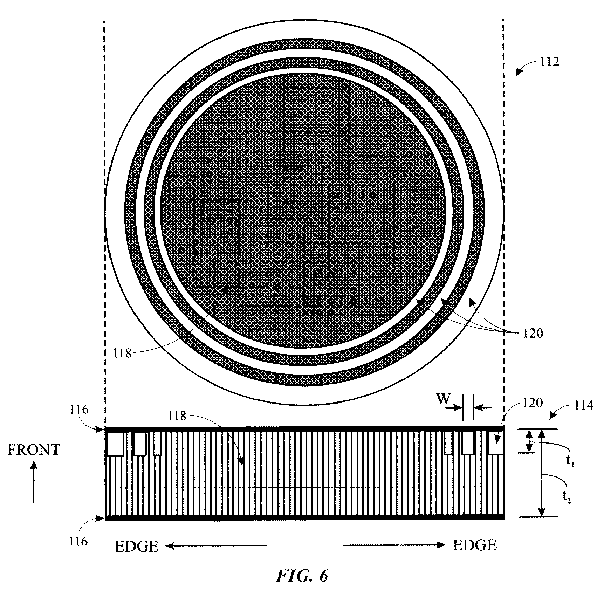

As set forth above, the present disclosure aims to apodize the emission and/or reception profile of piezo-composite elements used in ultrasonic transducers. This may be achieved by disabling certain areas of the piezoelectric layer through milling and refilling with epoxy or other insulating materials of low permittivities. Such an approach circumvents a potential limitation of transducers having a conductive front face, which may not allow the deposition of a certain electrode pattern. The more abrupt the change of the initial pressure profile is at the edges of the active element, the more pronounce the side lobe pattern will be. A Gaussian like pressure profile may be desirable for the aforementioned reasons. However, while a pressure profile in exact Gaussian distribution across the face of apodized transducer may eliminate side lobes, for a fixed available area (across the face of transducer), a complete Gaussian apodization means a significant beam-width reduction, which may increase beam spreading. Therefore, it is worth pointing out that there is a tradeoff in the extent of apodization, and in the present disclosure, only some apodization of the response towards the edge of the disk like transducer may be desirable without necessarily going to the extreme of a Gaussian profile. With this in mind, such designs in accordance with embodiments in the present disclosure are described in FIGs. 6 to 8.

Referring to FIG. 6, a layer of piezo-composite material according to one embodiment of the present disclosure is shown in a top view 112 and a cross-sectional view 114. The active piezoelectric layer 118 includes at least one axial centric groove 120 filled with an insulating material such as epoxy. However, in some cases, a high-permittivity filler such as ceramic powder may also be included in the epoxy to allow the use of a thicker insulating layer that is easier to manufacture. The groove/grooves 120 may be directly under the electrode 116 closer to the front (or on the back side), and the orientation and dimensions of the grooves 120 are symmetrical in directions towards the edge. In another example, the orientation and dimensions of the grooves 120 may be asymmetrical towards the edge. In one example, each of the grooves 120 has a width w and a thickness t_{1,} and the active piezoelectric layer 118 has a thickness t₂. In another example, a distance between adjacent grooves 120 may vary (e.g., the spacing of the grooves 120 may vary). These are dimensions that may be adjusted to reduce side lobes and achieve a more Gaussian like emission/reception profile.

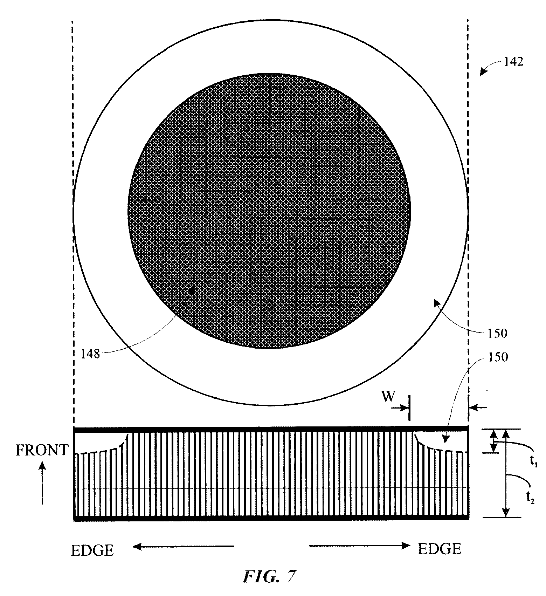

In one example, the thickness t₁ of the grooves 120 may be the same as the thickness t₂ of the active piezoelectric layer 118. In another example, the thickness t₁ of the grooves 120 may be thin (e.g., less than 30% of the thickness t₂ of the active piezoelectric layer 118). In another example, the grooves 120 may each have a different thickness t₁, and the thickness ratio t₁/t₂ may vary in the direction towards the edge. Furthermore, the grooves 120 that are closer to the edge may have greater thickness ratios t₁/t₂ than the grooves 120 that are farther away from the edge (e.g., closer towards the center of the disk-like transducer in the radial direction). The grooves 120 may also each have a different width w, and value of w may vary in the direction towards the edge. For example, the grooves 120 that are closer to the edge may have greater w values than the grooves 120 that are farther away from the edge. The above mentioned embodiments by itself or in combination thereof are aimed to apodize the emission/reception profile of piezo-composite elements to be a nearly Gaussian profile. Referring to FIG. 7, a layer of piezo-composite material according to one embodiment of the present disclosure is shown in a top view 142 and a cross-sectional view 144. The active piezoelectric layer 148 is tapered in its end region towards the edge, wherein the tapered region is filled with an insulating material of low permittivity such as epoxy. For the reason as set forth above, a high-permittivity filler such as ceramic powder may be included in the epoxy. The insulating material filled layer 150 may be directly under the electrode 146 closer to the front (or back), and the orientation and dimensions of the insulating material filled layer 150 is symmetrical in directions towards the edge. The insulating material filled layer 150 has a width w and a thickness t₁, and the active piezoelectric layer 148 has a thickness t₂. Furthermore, depending on the dimensions of the insulating material filled layer 150, the outline 156 of the boundary between elements 148 and 150 may vary. In some cases, the thickness t₁ of the insulating material filled layer 150 may be between 0% and 5 % of the thickness t₂ of the active piezoelectric layer 148. The thickness t₁ may be a constant value or it may vary in the direction toward the edge. In general, the thickness t₁ may be big enough to be mostly or fully electrically insulating. And for the tapering approach, the relative thickness of the layer may be calculated without much impact of the piezo-disc thickness. In other cases, the insulating material filled layer 150 may have varying thickness t₂ in directions towards the edge (e.g., varying t₁/t₂ ratio as a function of width w), and the t₁/t₂ ratio may increase towards the edge. Furthermore, the varying t₁/t₂ ratio as a function of width w may also be achieved via steps rather than a smooth curve.

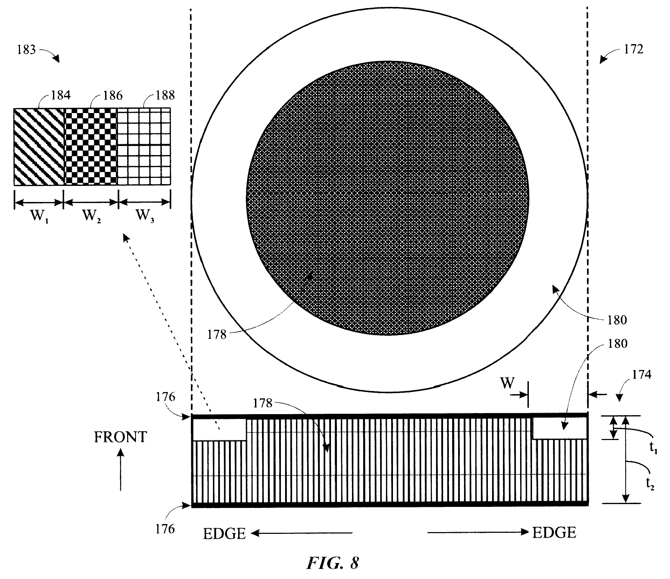

Referring to FIG. 8, a layer of piezo-composite material according to one embodiment of the present disclosure is shown in a top view 172 and a cross-sectional view 174. The active piezoelectric layer 178 is tapered in its end region towards the edge, wherein the tapered region is filled with different insulating materials, which further divide the tapered region as shown by numeral 183. As such, the insulating layer 180 may include more than one materially different sub-regions having the same or different widths (w₁, w₂, and w₃, etc.) but the same thickness t₁. One example of the materially different sub-regions may be sub-region 184, 186 and 188 each is made of a different type of epoxy resin. Another example may be sub-region 184, 186 and 188 each is made of the same type of epoxy, but such epoxy contains different amounts of fillers (e.g., high-permittivity ceramic powders). Through varying the constituents of the insulating layer 180 in different sub-regions, a conductive gradient (in radial direction towards the edge) may be achieved. The gradient may be tailored such that regions closer to the edge of the disk-like ultrasonic transducer have higher insulating strength than regions closer to the center.

Referring to FIG. 9, a layer of piezo-composite material according to one embodiment of the present disclosure is shown in a top view 202 and a cross-sectional view 204. The active piezoelectric layer 208 includes at least one strip 210, planarly extending across the piezoelectric layer 208 (e.g., planarly extending from one edge to the other) and filled with an insulating material such as epoxy. In another example, not all of the strips 210 are extending across the piezoelectric layer 208 (e.g., the strips 210 may planarly extend through only a portion of the piezoelectric layer 208, but not all the way across the piezoelectric layer). In some cases, a high-permittivity filler such as ceramic powder may also be included in the epoxy to allow the use of a thicker insulating layer that is easier to manufacture. The strip/strips 210 may be directly under the electrode 206 closer to the front (or on the back side), and the orientation and dimensions of the strips 210 are symmetrical in directions towards the edge. In another example, the orientation and dimensions of the strips 210 may be asymmetrical towards the edge. In one example, each of the strips 210 has a width w and a thickness t₁, and the active piezoelectric layer 208 has a thickness t₂. These are dimensions that may be adjusted to reduce side lobes and achieve a more Gaussian like emission/reception profile.

In one example, the thickness t₁ of the strips 210 may be the same as the thickness t₂ of the active piezoelectric layer 208. In another example, the thickness t₁ of the strips 210 may be thin (e.g., less than 30% of the thickness t₂ of the active piezoelectric layer 208). In another example, the strips 210 may each have a different thickness t₁, and the thickness ratio t₁/t₂ may vary in the direction towards the edge. Furthermore, the strips 210 that are closer to the edge may have greater thickness ratios t₁/t₂ than the strips 210 that are farther away from the edge (e.g., closer towards the center of the disk-like transducer in the radial direction). The strips 210 may also each have a different width w, and value of w may vary in the direction towards the edge. For example, the strips 210 that are closer to the edge may have greater w values than the strips that are farther away from the edge. The above mentioned embodiments by itself or in combination thereof are aimed to apodize the emission/reception profile of piezo-composite elements to be a nearly Gaussian profile.

Referring to FIG. 10, a layer of piezo-composite material according to one embodiment of the present disclosure is shown in a top view 230. The active piezoelectric layer 232 includes at least one irregularly shaped region 234 filled with an insulating material such as epoxy. In one example, the piezo-composite material may have a disk like geometry having an elliptical shape as shown or any other irregular or regular shapes suitable. In another example, the orientation and dimension of the random shaped region 234 may be symmetrical or asymmetrical towards the edge. In one example, the irregularly shaped region has a thickness t₁ (not shown), and the active piezoelectric layer 232 has a thickness t₂ (not shown). These are dimensions that may be adjusted to reduce side lobes and achieve a more Gaussian like emission/reception profile. In one example, the thickness t₁ of the irregularly shaped regions 234 may be the same as the thickness t₂ of the active piezoelectric layer 232. In another example, the thickness t₁ of the irregularly shaped regions 234 may be thin (e.g., less than 30% of the thickness t₂ of the active piezoelectric layer 232). In another example, the irregularly shaped regions 234 may each have a different thickness t₁, and the thickness ratio t₁/t₂ within the irregularly shaped regions 234 may vary in the direction towards the edge. Furthermore, the thickness ratio t₁/t₂ within the irregularly shaped regions 234 may increase (e.g., greater t₁/t₂ value) towards the edge. The above mentioned embodiments by itself or in combination thereof are aimed to apodize the emission/reception profile of piezo-composite elements to be a nearly Gaussian profile.

The specific embodiments described above have been shown by way of example, and it should be understood that these embodiments may be susceptible to various modifications and alternative forms. It should be further understood that the claims are not intended to be limited to the particular forms disclosed, but rather to cover modifications, equivalents, and alternatives falling within the spirit and scope of this disclosure.

## Claims

1. A transducer configured to emit or receive an acoustic signal, the transducer comprising:
a front electrode;
a central layer behind the front electrode, wherein the central layer has a substantially constant first thickness from a central point to an edge of the central layer, wherein the central layer comprises:
a piezo-composite body having a second thickness within the first thickness, wherein the second thickness of the piezo-composite body varies from the central point to the edge; and
an insulating material having a third thickness, wherein the third thickness of the insulating material varies from the central point to the edge in an opposite manner to the second thickness;
wherein the first thickness is equal to the second thickness plus the third thickness; and
a back electrode behind the central layer, having a back face coupled to a backing material.

2. The transducer of claim 1, wherein variations in the second thickness of the piezo-composite body and the third thickness of the insulating material from the central point to the edge cause the piezo-composite body to cause the transducer to emit or receive an acoustic signal having an excitation profile with reduced side lobes in comparison to a different transducer with another piezo-composite body having a similar geometry but a single thickness that does not vary from the central point to the edge.

3. The transducer of claims 1 or 2, wherein the excitation profile of the acoustic signal approximates a mathematical model.

4. The transducer of any of the above claims, wherein the piezo-composite body is made of piezoelectric rods in an epoxy matrix.

5. The transducer of any of the above claims, wherein the insulating material is made of epoxy, or epoxy containing ceramic fillers, or any combination thereof.

6. The transducer of any of the above claims, wherein the third thickness is smaller than 5% of the first thickness.

7. The transducer of any of the above claims, wherein the second thickness of the piezo-composite body differs in various locations to form one or more axial centric grooves along a radial direction towards a radial edge, wherein the one or more axial centric grooves have an identical thickness value and a varying width value along the radial direction towards the radial edge.

8. The transducer of any of the above claims, wherein the second thickness of the piezo-composite body differs in various locations along a radial direction towards a radial edge to form a tapered radial edge, wherein the second thickness decreases towards the radial edge.

9. The transducer of any of the above claims, wherein the second thickness of the piezo-composite body decreases along the radial direction towards the radial edge via one or more step-wise transitions.

10. The transducer of any of the above claims, wherein the second thickness of the piezo-composite body differs in various locations to form one or more strips extending across the piezo-composite body and symmetrical with respect to the central point, wherein the one or more strips have an identical thickness value and a varying width value along the radial direction towards the radial edge.

11. The transducer of any of claims 1-9, wherein the second thickness of the piezo-composite body differs in various locations to form one or more irregularly shaped regions along a radial edge, wherein the one or more irregularly shaped regions have an identical thickness value and a varying characteristic width value along the radial direction towards the radial edge.

12. A method for making a transducer configured to reduce side lobes, comprising:
providing a central layer between a front electrode and a back electrode of the transducer, wherein the central layer has a substantially constant first thickness throughout, and comprises:
a piezo-composite body having a second thickness along an axial direction, and a width along a radial direction towards an radial edge; and
an insulating material having a third thickness;
varying the second thickness of the piezo-composite body to differ in various locations along the radial direction towards the radial edge; and
varying the third thickness of the insulating material such that the first thickness of the central layer comprises the third thickness of the insulating material combined with the second thickness of the piezo-composite body.

13. The method of claim 12, wherein the central layer is designed to produce an excitation profile that nearly approximates a mathematical model.

14. The method of claims 12 or 13, wherein varying the second thickness of the piezo-composite body to differ in various locations is designed to form one or more axial centric grooves along the radial direction towards the radial edge, wherein the one or more axial centric grooves have an identical thickness value and a varying width value along a radial direction towards the radial edge.

15. The method of claims 12-14, wherein varying the second thickness of the piezo-composite body to differ in various locations decreases along the radial direction towards the radial edge via one or more step-wise transitions.
